# EUROPÄISCHE PATENTANMELDUNG

(11) **EP 1 347 113 A1**
(43) Veröffentlichungstag der Anmeldung: **24.09.2003**
(21) Anmeldenummer: 03001473.2
(22) Anmeldetag: 23.01.2003
(51) Int. Cl.: E04C 2/52, F24J 2/04

(54) **Fertigbauelement mit integriertem Solarzellenmodul**

(30) Priorität: 22.02.2002 DE 20202801 U
(71) Anmelder: EnBW Energie Baden-Württemberg AG, 76131 Karlsruhe (DE)
(72) Erfinder: Riffel, Siegfried, 74388 Talheim (DE)
(74) Vertreter: Petersen, Frank, Dipl.-Ing.

(57) **Zusammenfassung**

Die Erfindung betrifft ein Fertigteilbauelement aus Stahlbeton für eine Wand oder ein Dach eines Gebäudes, insbesondere eines Wohnhauses, mit einem integrierten Solarzellenmodul. Bei einer solchen Vorrichtung soll das integrierte Solarzellenmodul gekühlt werden, ohne hierfür einen hohen Aufwand bezüglich Statik oder unterzubringender Volumina für ein Kühlmedium betreiben zu müssen.

Hierzu wird erfindungsgemäß vorgeschlagen, in den Stahlbeton des Fertigteilbauelementes nach außen geführte Wärmeleitelemente zu integrieren, die sowohl als metallische Stangen ausgebildet sein können als auch als mit einem Kühlmedium durchströmbare Rohre. Vorzugsweise wird das Fertigteilbauelement dabei mindestens zweischalig ausgeführt und die das Solarzellenmodul tragende Schale ist durch Dämmmaterial von den restlichen Schalen thermisch getrennt.

## Beschreibung

Die Erfindung betrifft ein Fertigteilbauelement aus Stahlbeton für eine Wand oder ein Dach eines Gebäudes, insbesondere eines Wohnhauses, mit einem integrierten Solarzellenmodul.

Ein derartiges Fertigteilbauelement ist beispielsweise bekannt aus der DE-A-197 16 932. Hier wird erwähnt, dass ein Fertigteildach mit Photovoltaikelementen und/oder Sonnenkollektoren versehen werden kann.

Es ist bekannt, dass der Wirkungsgrad eines Photovoltaik- bzw. Solarzellenmoduls neben anderen Faktoren auch von der Temperatur der Solarzellen abhängt. Die Lehrlaufspannung und somit auch die maximal entnehmbare Leistung sinkt mit zunehmender Temperatur. Steigt beispielsweise die Solarzellentemperatur auf zirka 70 °C, nimmt der Wirkungsgrad um bis zu 30 % ab bezogen auf eine Temperatur von 25 °C. Deshalb ist beim Aufbau von Solarzellenmodulen auf möglichst gute Kühlung der Solarzellenanordnung zu achten.

Hierzu wurde beispielsweise in der DE-A-38 31 631 vorgeschlagen, das Solarzellenmodul auf seiner gesamten Rückfläche mit einem großen, flüssigkeitsgefüllten Behälter zu versehen, wobei die Flüssigkeit im Laufe eines Tages Wärmeenergie aus dem Solarzellenmodul aufnimmt und speichert. Ähnliches ist bekannt aus der DE-A-197 47 325.

Bei diesen Vorrichtungen ist es aber von Nachteil, dass die Elemente zur Kühlung der Solarelemente und Wärmespeicherung erheblichen baulichen Aufwand benötigen, um den volumenmäßigen und statischen Anforderungen, die deren Montage benötigen, gerechtwerden zu können.

Aufgabe der vorliegenden Erfindung ist es daher, eine Vorrichtung wie oben anzugeben, die es ermöglicht, ein integriertes Solarzellenmodul zu kühlen, ohne hierfür einen hohen Aufwand bezüglich Statik oder unterzubringender Volumina betreiben zu müssen.

Diese Aufgabe wird erfindungsgemäß dadurch gelöst, dass in den Stahlbeton des Fertigteilbauelementes nach außen geführte Wärmeleitelemente integriert sind.

Der Vorteil der Erfindung liegt darin, dass das Stahlbetonfertigteilbauelement selber als Massivabsorber fungiert und die von ihm aufgenommene Wärmeenergie durch die Wärmeleitelemente abzuleiten ist. Das Stahlbetonelement kann dabei bei relativ geringem Volumen relativ viel Wärmeenergie aus dem Solarzellenmodul abführen. Dabei übernimmt es aber gleichzeitig selber statische und konstruktive Funktionen, so dass hierfür nicht separate Elemente vorzusehen sind. Dies führt letztlich auch zu einer preiswerteren Gestaltung eines aus derartigen Fertigteilbauelementen hergestellten Gebäudes oder Daches.

Eine Möglichkeit die Wärmeleitelemente auszuführen wird darin gesehen, metallische Stangen vorzusehen. Beispielsweise hat normaler Baustahl eine recht gute Wärmeleitfähigkeit. Derartige Stangen haben dabei den Vorteil, über lange Zeiträume betriebssicher Wärme ableiten zu können.

Es wird allerdings vorgezogen, die Wärmeleitelemente als Rohre auszubilden, durch die dann ein Kühlmedium geleitet wird. Dies hat den Vorteil, dass bei gesteigerten Temperaturen eine gesteigerte Kühlung erreichbar ist durch Erhöhung des Kühlmediumdurchsatzes. Die Rohre können beispielsweise aus Kupfer, aus Stahl oder aus Kunststoff, wie insbesondere HDPE etc. bestehen.

Vorzugsweise sind die Wärmeleitelemente mit einer Wärmerückgewinnungsanlage verbunden, die mit dem Fertigteilbauelement gekoppelt ist. Bei dieser Wärmerückgewinnungsanlage kann es sich beispielsweise um eine Wärmepumpe und/oder einen Pufferspeicher handeln, die gegebenenfalls auch in die Warmwasserbereitung oder eine Niedertemperaturheizung integriert sind, die in dem Gebäude vorgesehen sind. Eine andere Wärmerückgewinnungsanlage ist beispielsweise eine Kühlvorrichtung, die beispielsweise auf Absorbtionsbasis arbeitet.

Die Wärmerückgewinnungsanlage wird vorzugsweise mit dem von dem Solarmodul gelieferten Strom betrieben, sie kann aber gegebenenfalls auch durch Strom aus dem Netz betrieben werden.

Ansonsten kann der Strom aus dem Solarzellenmodul sowohl innerhalb des Hauses verbraucht, als auch in das öffentliche Netz eingespeist werden.

Um die Wärmedämmung innerhalb des Hauses durch die in das Fertigteilbauelement integrierten Solarzellenmodule nicht zu verschlechtern, wird vorgeschlagen, das Element mindestens zweischalig auszubilden. Dabei ist dann das Solarzellenmodul und die dieses tragende Schale durch Dämmmaterial von den restlichen Schalen wärmetechnisch abgekoppelt. Insbesondere werden die Schalen dabei beispielsweise durch einen Gitterträger aus Edelstahl von einen der beabstandet, der gute Eigenschaften hat bezüglich der gewünschten thermischen Trennung und der Übertragung von statischen Kräften bei gleichzeitig hervorragenden Korrosionseigenschaften.

Für derartiges Dämmmaterial ist zwar einerseits lediglich stehende Luft möglich, es ist aber auch im Sinne der Erfindung, hier Stein- oder Glaswolle vorzusehen oder aber einen aufgeschäumten Kunststoff wie beispielsweise Polystyrol etc. Auch Blähglas, Zellulose, Holzspäne oder textile Dämmstoffe sind verwendbar.

Die Außenschale ist unabhängig von der Innenschale selbständig in der Lage, die durch das montierte Solarzellenmodul aufgebrachten Lasten zu tragen. Sie wird hierfür entsprechend dimensioniert.

Um die Wärmeabfuhr aus dem Solarzellenmodul möglichst gut gewährleisten zu können, wird vorgeschlagen, es mittels einer wärmeleitenden Kontaktmasse oder einem Thermogel auf dem Fertigteilbauelement zu montieren. Eine zusätzliche Fixierung bzw. Befestigung mittels Rasten oder Schrauben etc. ist hierdurch allerdings nicht ausgeschlossen. Auch kann ein Montagerahmen gegebenenfalls eine lösbare Verbindung ermöglichen, die sinnvoll ist für eine schnellere Auswechselbarkeit eines beispielsweise durch Sturm, Hagel o. ä. beschädigtes Solarzellenmoduls.

Auch liegt es im Rahmen der Erfindung, das Solarzellenmodul in einer Ausnehmung des Fertigteilbauelementes einzusetzen. Durch einen dabei rings um das Solarzellenmodul umlaufenden, hervorstehenden Rand ist das Solarzellenmodul gegebenenfalls auch vor Schäden besser geschützt.

Weitere Vorteile und Merkmale der Erfindung ergeben sich aus der nachfolgenden Beschreibung eines Ausführungsbeispiels. Dabei zeigt
- Figur 1: den Schnitt durch ein Fertigteilbauelement;
- Figur 2: die Aufsicht auf ein Fertigteilbauelement.

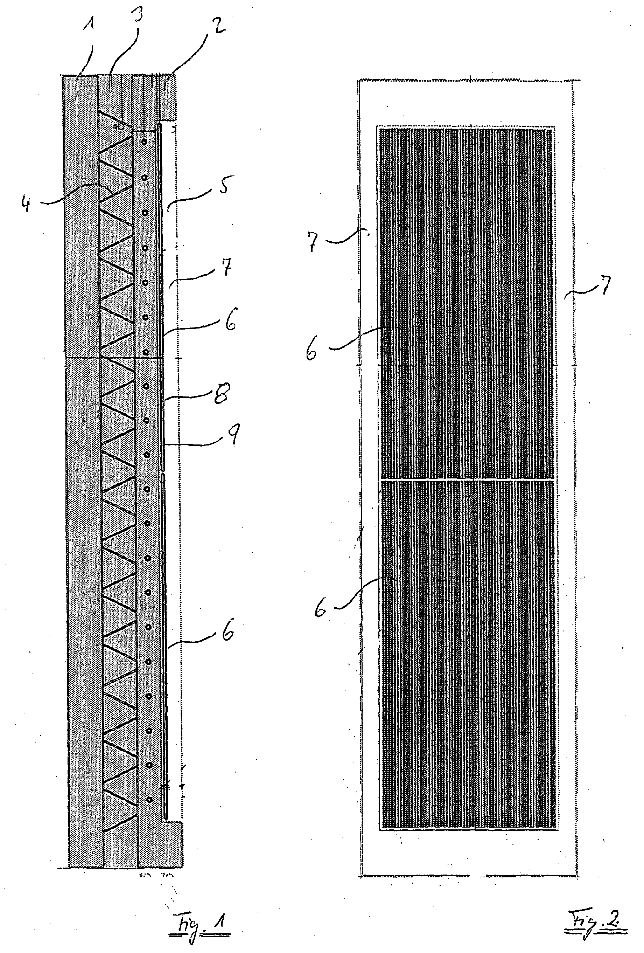

In Figur 1 ist der Schnitt durch ein Fertigteilbauelement aus Stahlbeton dargestellt. Ein derartiges Fertigteilbauelement kann entweder für eine Wand oder aber ein Dach eines Gebäudes benutzt werden. Es kann dabei entsprechend den spezifischen Anforderungen auch noch mit anderen Materialien wie einer Putzschicht oder einer üblichen Dacheindeckung aus Metall, Holz, Glas oder auch Dachziegeln etc. versehen werden.

Das hier dargestellte Fertigteilbauelement hat eine Innenschale 1 sowie eine Außenschale 2. Zwischen diesen befindet sich eine Dämmung 3, die beispielsweise aus Stein- oder Glaswolle besteht oder aber aus Polystyrol etc. Auch Materialien wie Blähglas, Zellulose, Holzspäne oder textile Dämmstoffe können zum Einsatz kommen.

Die Innenschale 1 und die Außenschale 2 sind durch die Dämmmaterialien 3 hindurch verbunden über einen Gitterträger 4, dessen - hier nicht dargestellten-Gurte in die Innenschale 1 bzw. die Außenschale 2 integriert sind. Über diesen Gitterträger werden die statischen Kräfte von der obenliegenden Außenschale auf die hier untenliegende Innenschale übertragen.

Die Schalen sind dabei aus Beton oder auch Polymerbeton, Faserbeton etc. gegossen und gegebenenfalls mit einer Bewehrung aus Stahl/Eisen, Gewebe, Textil oder Karbonfasern etc. versehen.

Die Außenschale 2 weist außenliegend eine Aussparung 5 auf, in die im hier dargestellten Beispiel zwei Solarzellenmodule 6 eingesetzt sind. Um die in die Aussparung 5 eingesetzten Solarzellenmodule 6 verläuft dabei ein über den Rand der Solarzellenmodule 6 hochstehender Rand 7.

Die Außenschale 2 ist dabei so dimensioniert, dass sie die durch die Solarzellenmodule 6 aufgebrachten Lasten problemlos tragen kann.

Die Solarzellenmodule 6 sind durch eine Thermogel- oder Kontaktmassenschicht 8 thermisch leitet und mit der Außenschale 2 verbunden.

Bei Auftreten von Sonnenlicht auf das Solarzellenmodul 6 (vorzugsweise ein sogenanntes CIS-Solarmodul) erwärmt sich dieses. Diese ungewünschte Wärme wird über die Kontaktmasse 8 an die Außenschale 2 abgegeben, die somit unmittelbar aufgrund ihrer Masse als Absorber fungiert, um die Temperatur des Solarzellenmodules nicht unnötig ansteigen zu lassen.

Damit dabei auch die Temperatur der Außenschale 2 auf Dauer niedrig zu halten ist, sind in die Außenschale 2 nach außen geführte Wärmeleitelemente 9 integriert. Damit ist die Außenschale 2 als sogenannter Massivabsorber ausgebildet.

Es handelt sich bei den Wärmeleitelementen beispielsweise um in die Außenschale 2 eingegossene metallische Stangen, die ihre Wärme abgeben oder aber um ein durch Kühlmittel durchströmtes Rohr. Die Wärmeenergie wird dabei vorzugsweise durch benachbarte, im wesentlichen baugleiche Fertigteilbauelemente geleitet, mit denen das dargestellte Element verbunden ist zur Bildung einer Wand- oder einer vorzugsweise geneigten Dachfläche. Sollten diese benachbarten Flächenelemente nicht selbst mit einem Solarzellenmodul versehen sein, wirken deren Außenschalen aufgrund ihrer zusätzlichen Masse mit als Absorber. Sie können aber auch beispielsweise aus der Umgebung zusätzlich Wärme aufnehmen und fungieren dann ebenfalls als Massivabsorber. Um dies zu verbessern und um die Optik von mehreren nebeneinander angeordneten Fertigteilbauelementen mit und ohne integrierte Solarzellenmodule zu vereinheitlichen, kann auf Bauelementen ohne Solarzellenmodul auch eine Blindscheibe montiert sein.

Das genannte Kühlmittel kann durch die Wärmeleitelemente hindurchgepumpt werden, die dazu gegebenenfalls auch meanderförmig in der Außenschale 2 verlegt sind, um dann in eine Wärmepumpe o. ä. geleitet zu werden, wo die thermische Energie genutzt wird, beispielsweise für eine Raumheizung, Kühlung, eine Warmwasserbereitung o. ä.

Es sei an dieser Stelle auch erwähnt, dass mit derartigen Wärmeleitelementen es beispielsweise im Winter auch möglich ist, die Solarzellenmodule zu beheizen, um diese damit von einer auf ihnen liegenden Schneeschicht zu befreien.

Zusammenfassend muss in der erfindungsgemäßen Vorrichtung besonders der Vorteil gesehen werden, dass das Fertigteilbauelement fabrikmäßig vorfertigbar ist, wobei dabei gleichzeitig auch die Wärmeleitelemente eingegossen werden können. Man hat dabei nicht nur den Vorteil einer preiswerten Fertigung sondern die Kühlung für die Solarzellenmodule ist direkt in ein statisch tragendes Element integriert. Durch das Eingießen der Wärmeleitelemente in den Stahlbeton ist dabei unter anderem auch ein Schutz gegen Beschädigungen erreicht.

Insbesondere wird mit einem Bauelement gemäß der Erfindung die photovoltaische Stromproduktion gekoppelt mit einer verbesserten Wärmegewinnung für eine Wärmepumpenanlage.

## Patentansprüche

1. Fertigteilbauelement aus Stahlbeton für eine Wand oder ein Dach eines Gebäudes, insbesondere eines Wohnhauses, mit einem integrierten Solarzellenmodul (6),
**dadurch gekennzeichnet,**
**dass** in den Stahlbeton (2) nach außen geführte Wärmeleitelemente (9) integriert sind.

2. Fertigteilbauelement gemäß Anspruch 1,
**dadurch gekennzeichnet,**
**dass** die Wärmeleitelemente (9) als metallische Stangen ausgebildet sind.

3. Fertigteilbauelement gemäß Anspruch 1,
**dadurch gekennzeichnet,**
**dass** die Wärmeleitelemente (9) als Rohre ausgebildet sind, die mit einem Kühlmedium durchströmbar sind.

4. Fertigteilbauelement gemäß Anspruch 1,
**dadurch gekennzeichnet,**
**dass** es mindestens zweischalig ist und die das Solarzellenmodul (6) tragende Schale (2) durch Dämmmaterial (3) von den restlichen Schalen (1) thermisch getrennt ist.

5. Fertigteilbauelement gemäß Anspruch 1,
**dadurch gekennzeichnet,**
**dass** das Solarzellenmodul (6) mittels einer wärmeleitenden Kontaktmasse (8) auf dem Element (2) befestigt ist.

6. Fertigteilbauelement gemäß Anspruch 1,
**dadurch gekennzeichnet**
**dass** die Wärmeleitelemente (9) mit einer mit dem Fertigbauelement gekoppelten Wärmerückgewinnungsanlage verbunden sind.

7. Fertigteilbauelement gemäß Anspruch 6,
**dadurch gekennzeichnet,**
**dass** die Wärmerückgewinnungsanlage mit Strom aus dem Solarzellenmodul (6) gespeist ist.

8. Fertigteilbauelement gemäß Anspruch 1,
**dadurch gekennzeichnet,**
**dass** das Solarzellenmodul (6) in einer Aussparung (5) des Elementes angeordnet ist.

9. Fertigteilbauelement gemäß Anspruch 1,
**dadurch gekennzeichnet,**
**dass** das Solarzellenmodul über einen lösbaren Montagerahmen anbringbar ist.
